# EUROPÄISCHE PATENTANMELDUNG

(11) **EP 4 047 635 A1**
(43) Veröffentlichungstag der Anmeldung: **24.08.2022**
(21) Anmeldenummer: 21157857.0
(22) Anmeldetag: 18.02.2021
(51) Int. Cl.: H01L 21/02

(54) **VERFAHREN ZUR HERSTELLUNG VON SCHEIBEN AUS EINEM ZYLINDRISCHEN STAB AUS HALBLEITERMATERIAL**

(71) Anmelder: Siltronic AG, 81677 München (DE)
(72) Erfinder: Pietsch, Georg, 84489 Burghausen (DE); Junge, Joachim, 84489 Burghausen (DE)
(74) Vertreter: Staudacher, Wolfgang

(57) **Zusammenfassung**

Verfahren zur Herstellung von Scheiben aus einem zylindrischen Stab aus Halbleitermaterial mit einer Achse und einer Kennkerbe in der Mantelfläche des Stabs und parallel zur Achse, umfassend in der angegebenen Reihenfolge
(a) das gleichzeitige Abtrennen einer Vielzahl von Scheiben vom zylindrischen Stab mittels Drahtsägen in Gegenwart eines Schneidmittels;
(b) das Ätzen der Scheiben mit einem alkalischen Ätzmittel in einem Ätzbad bei einer Temperatur von 20 °C bis 50 °C und während einer Verweildauer, wobei weniger als 5/1000 einer anfänglichen Scheibendicke als Materialabtrag von jeder der Scheiben entfernt wird; und
(c) das Schleifen der Scheiben mittels simultanem Doppelseitenschleifen mit einem ringförmigen Schleifbelag als Werkzeug.

## Beschreibung

Die Erfindung bezieht sich auf ein Verfahren zur Herstellung von Scheiben aus einem zylindrischen Stab aus Halbleitermaterial umfassend das Abtrennen der Scheiben vom Stab mittels Drahtsägen und das beidseitige Schleifen der Scheiben.

Für eine Vielzahl an Anwendungen werden gleichförmige Scheiben mit guter Planparallelität von Vorder- und Rückseite benötigt, die arm sind an kristallinen und strukturellen Defekten. Ein Beispiel sind Scheiben aus einkristallinem Halbleitermaterial (Wafer) zum Strukturieren mikroelektronischer Bauelemente. Ein Beispiel für Halbleitermaterial ist Silicium. Derartige Scheiben werden durch Abtrennen von einem zylindrischen Werkstück (Stab) aus einkristallinem Silicium erhalten und einer Span abhebenden ("mechanischen") Bearbeitung unterzogen. Häufig erfolgt das Abtrennen mittels Drahtsägen (MWS, multi-wire slicing) und die Span abhebende Bearbeitung mittels simultanem Doppelseitenschleifen (DDG, double-disk grinding).

Ein Verfahren und eine Vorrichtung zum Drahtsägen sind beispielsweise aus der DE 10 2016 211 883 A1 oder der DE 10 2013 219 468 A1 bekannt. Beim Drahtsägen wird ein Draht derart spiralförmig um mindestens zwei Drahtführungsrollen herumgeführt, dass zwei Drahtführungsrollen ein dem Werkstück zugewandtes Gatter aus parallel zueinander verlaufenden Drahtabschnitten aufspannen. Die Drahtführungsrollen weisen die Form gerader Kreiszylinder auf mit Achsen, die parallel zueinander ausgerichtet sind und um die sie gedreht werden können. Die Mantelflächen der Drahtführungsrollen sind mit einer Vielzahl kreisförmig geschlossener und in Ebenen senkrecht zu den Achsen verlaufender Rillen versehen, die den Draht führen. Gleichsinniges Drehen der Drahtführungsrollen erzeugt eine Relativbewegung zwischen Drahtabschnitten und Werkstück. Eine Drahtsäge weist ferner eine Zustellvorrichtung auf, an der das Werkstück über eine Sägeleiste befestigt ist und die das Werkstück senkrecht auf das Drahtgatter zustellt. Die Relativbewegung und die Anwesenheit eines abrasiv wirkenden Schneidmittels erzeugen bei Kontakt von Werkstück und Drahtgatter einen Materialabtrag vom Werkstück. Bei fortgesetztem Zustellen bilden die Drahtabschnitte Trennspalte im Werkstück aus, und das Drahtgatter arbeitet sich langsam durch das gesamte Werkstück hindurch, bis das Drahtgatter vollständig innerhalb der Sägeleiste, mit der das Werkstück mittels einer Klebefuge verbunden ist, zu liegen kommt. Das Werkstück ist dann vollständig in Scheiben aufgetrennt, die wie Zinken eines Kamms, nur durch die Klebefuge gehalten, an der Sägeleiste hängen.

Das Drahtsägen kann nach Drahttrennläppen und Drahttrennschleifen unterschieden werden. Beim Drahttrennläppen ist der Draht zunächst frei von abrasiv wirkenden Stoffen, und das Schneidmittel wird in Form einer Aufschlämmung (slurry) als frei bewegliches Korn in einer Trägerflüssigkeit zugeführt. Drahttrennläppen ist somit gekennzeichnet durch eine Dreikörper-Wechselwirkung zwischen dem Draht, dem im Slurry enthaltenen Schneidmittel und dem Werkstück. Beim Drahttrennschleifen sind in der Oberfläche des Drahts abrasiv wirkende Schneidmittel verankert, und es wird eine Schneidflüssigkeit zugeführt, die als Kühlschmiermittel wirkt. Drahttrennschleifen ist gekennzeichnet durch eine Zweikörper-Wechselwirkung zwischen dem Schneidmittel in der Drahtoberfläche und dem Werkstück.

Der Draht besteht meist aus hypereutektischem perlitischem Stahl (Pianodraht) und ist meist mit einer dünnen Schicht aus Messing oder Zink beschichtet, deren Duktilität bei der Drahtherstellung mittels Ziehen durch Düsen (dies) für eine Festkörperschmierung sorgt und beim Drahtsägen als Korrosionsschutz wirkt. Beim Drahttrennläppen besteht das Schneidmittel meist aus Siliciumcarbid (SiC) und die Trägerflüssigkeit meist aus Öl oder Glycol. Beim Drahttrennschleifen besteht das Schneidmittel meist aus Diamanten, die in der Oberfläche des Drahts fixiert sind, beispielsweise mittels Kunstharz oder galvanisch in einem Bett aus Nickel oder formschlüssig in die Oberfläche gepresst. Das Kühlschmiermittel ist meist Wasser, das ggf. mit Additiven beaufschlagt ist (Netzmittel, Korrosionsschutzmittel, Entschäumer). Der Draht wird üblicherweise von einer Frischdrahtspule abgewickelt und den Drahtführungsrollen zugeführt und nach dem Drahtsägen auf eine Altdrahtspule aufgewickelt.

Beim Drahttrennschleifen kommt Glattdraht zum Einsatz, beim Drahttrennläppen Glattdraht oder strukturierter Draht. Glattdraht besitzt die Form eines Kreiszylinders von sehr großer Höhe, nämlich der Länge des Drahts, und der Drahtdurchmesser entspricht dem Durchmesser des Zylinders. Strukturierter Draht umfasst einen Glattdraht, der entlang seiner gesamten Länge mit einer Vielzahl von Ausbuchtungen (protrusions) und Einstülpungen (indentations) in Richtungen senkrecht zur Drahtlängsrichtung versehen ist. Die Oberfläche eines strukturierten Drahts weist Vertiefungen und Erhöhungen auf, die wie Taschen wirken, in denen sich Slurry an den Draht anlagern kann, ohne beim Eintritt des Drahts in den Trennspalt oder während dessen Bewegung durch den Trennspalt abgestreift zu werden. Mit strukturiertem Draht ist ein besonders schnelles und kräftearmes Drahtsägen möglich. Ein Beispiel für einen strukturierten Draht beschreibt die WO 2006/067062 A1.

Drahtsägen kann mit unidirektionaler oder reziproker Drahtbewegung erfolgen. Beim unidirektionalen Drahtsägen wird der Sägedraht über die gesamte Dauer des Trennvorgangs in einer Drahtlängsrichtung von der Frischdraht- zur Altdrahtspule bewegt. Beim Drahtsägen mit reziproker (bidirektionaler) Drahtbewegung wird der Sägedraht während des Abtrennvorgangs mittels mindestens eines Paares von Richtungsumkehrungen bewegt, wobei ein Paar an Richtungsumkehrungen ein erstes Bewegen des Drahts um eine erste Länge in eine erste Drahtlängsrichtung und ein zweites Bewegen des Drahts um eine zweite Länge in eine zweite, der ersten genau entgegengesetzte Richtung umfasst. Insbesondere kann das Drahtsägen mit reziproker Drahtbewegung eine Vielzahl derartiger Paare von Drahtrichtungsumkehrungen umfassen, wobei die erste Länge größer als die zweite Länge gewählt wird, so dass sich insgesamt der Drahtvorrat während es Trennvorgangs von der Frischdraht- zur Altdrahtspule hin verlagert. Das letztgenannte Verfahren wird als Drahtsägen im Pilgerschritt (pilgrim mode slicing, wire-reciprocating slicing) bezeichnet.

Eine mittels Drahtsägen erzeugte Scheibe hat die Form eines Zylinders mit geringer Höhe, nämlich der Dicke der Scheibe. Die Grundfläche des Zylinders bildet die Rückseite und die Deckfläche die Vorderseite der Scheibe. Zwischen Vorder- und Rückseite befindet sich die Kante der Scheibe als Nebenfläche. Am Umfang der Scheibe ist in der Regel eine mechanische Orientierungskennung in Form einer zum Zentrum der Scheibe weisenden Kerbe (notch) vorhanden. Um sie zu schaffen, wird die Mantelfläche des zylindrischen Stabs vor dem Drahtsägen mit einer Kennkerbe versehen, die parallel zu Achse des Stabs ausgerichtet ist.

Üblicherweise folgt dem Drahtsägen ein Span abhebender Bearbeitungsschritt nach, der zum Ziel hat, die durch das Drahtsägen kristallin geschädigten Oberflächenschichten von den Scheiben abzutragen, Abweichungen der Scheiben von der gewünschten möglichst planparallelen Form Material abtragend weiter zu reduzieren und eine Scheibenoberfläche zu erzeugen, die eine geringe Rautiefe und einen geringeren Grad an kristalliner Restschädigung aufweist. Als Bearbeitungsschritt kommt insbesondere das simultane Doppelseiten-Schleifen (DDG, double-disk grinding) in Betracht.

DE 101 42 400 B4 beschreibt beispielsweise eine Prozesssequenz zur Bearbeitung von Halbleiterscheiben, umfassend das Auftrennen eines Werkstücks in Scheiben (Schritt 1), das Verrunden der Kante der Scheiben (Schritt 2), das simultane Doppelseiten-Schleifen (Schritt 3), die Politur der Scheiben (Schritt 4) und gegebenenfalls zusätzlich zwischen Schritt 3 und Schritt 4 das Ätzen von mindestens einer der beiden Hauptflächen der Scheiben.

Das Doppelseiten-Schleifen und eine dafür geeignete Vorrichtung sind beispielsweise in der EP 1 193 029 B1 beschrieben. Beim DDG sind zwei Topfschleifräder mit Achsen kollinear zueinander und parallel zur Achse des Wafers angeordnet. Die Topfschleifräder tragen stirnseitig einen Ring aus Schleifzähnen, in die Diamant als Abrasiv eingebunden ist. Ein Topfschleifrad ist dabei der Vorder- und das andere der Rückseite des Wafers zugewandt. Die Topfschleifräder rotieren gegenläufig zueinander. Ihr Durchmesser ist jeweils etwas größer ist als der Radius des Wafers. Die Achsen der Schleifräder sind um den Betrag des Radius' des ringförmigen Schleifradbelags zur Waferachse parallelverschoben, so dass der Zahnaußenumfang der Schleifräder jeweils das Zentrum des Wafers überstreicht. Der Wafer wird mit Hilfe eines um seine Achse rotierenden Führungsrings (carrier ring) radial geführt. Der Führungsring enthält einen Mitnehmerstift (notch finger), der in die Kennkerbe des Wafers greift und so die Rotation des Führungsrings auf den Wafer überträgt.

In axialer Richtung wird der Wafer zwischen zwei Wasserkissen (hydro pads) hydrostatisch geführt. In der Mittelebene zwischen den beiden Wasserkissen gleichen sich die axialen Kräfte beider Wasserkissen genau aus. Eine ebene Scheibe, deren Vorder- und Rückseite nicht wesentlich aus dieser Mittelebene zwischen den beiden Wasserkissen herausragt, wird axial kräftefrei, quasi "frei schwebend" (free floating) geführt. Auf eine unebene, gewellte oder gekrümmte Scheibe, die teilflächig aus der Mittelebene zwischen den Wasserkissen herausragt, wirken lokal axiale Kräfte, die die Scheibe während der DDG-Bearbeitung elastisch verformen.

Durch symmetrisches Zustellen der Topfschleifräder auf die Mittelebene zwischen den Wasserkissen werden die Topfschleifräder in Kontakt mit dem Wafer gebracht ("grinding wheel touch-down"). Durch fortgesetztes symmetrisches Zustellen bewirkt das Abrasiv der Schleifzähne der Topfschleifräder dann mittels der Relativbewegung einen annähernd symmetrischen gleichzeitigen Materialabtrag von Vorder- und Rückseite des Wafers. Da die Schleifräder zu jedem Zeitpunkt nur einen Teil der Waferoberfläche überdecken und die gesamten Hauptflächen des Wafers erst durch die Rotation des Wafers nach und nach erfasst werden, bewirkt die fortwährende Zustellung der Schleifräder zunächst eine annähernd symmetrische Dickenabnahme des Wafers in einer Schraubenform. Die Zentrierung des Wafers zwischen den Wasserkissen und die erreichte Dicke des Wafers werden während des Schleifabtrags fortwährend mit Abstandsmesssensoren überprüft. Bei Erreichen einer vorgewählten Zieldicke des Wafers wird die weitere Zustellung der Topfschleifscheiben beendet und der Wafer noch um einige Umdrehungen unter den weiterhin rotierenden Topfschleifscheiben hindurchrotiert, wobei sich die Zustellkräfte der Topfschleifscheiben abbauen und die Topfschleifscheiben aus dem Material abtragenden Eingriff gelangen (Ausfeuern, spark out). Erst durch dieses Ausfeuern erhalten die Wafer ihre planparallele Form.

Mit DDG bearbeitete Wafer weisen einen charakteristischen Kreuzschliff auf. Die Kollinearität der Achsen der Schleifräder und auch der Grad der Planparallelität des Wafers kann anhand der Gleichmäßigkeit dieses Kreuzschliffes beurteilt und durch Anpassung der Achsneigung zueinander im Bereich weniger Winkelsekunden eingestellt werden.

Die Geometrie einer Scheibe, das heißt ihr Erscheinungsbild im Raum, kann stets vollständig durch deren Dicke und Form beschrieben werden. Misst man den Abstand an Messpunkten zwischen der Rückseite und der Vorderseite einer Scheibe, bilden die Abstände die Höhe einer Fläche ab, die die Dicke beschreibt. Von der Dicke können dickenbezogene Kenngrößen abgeleitet werden, beispielsweise TTV (total thickness variation) oder GBIR (global back-referenced indicator reading). Die Form einer Scheibe wird durch die Mittelfläche (median surface) beschrieben. Die Mittelfläche ist die Fläche, die alle neutralen Fasern der kräftefreien Scheibe enthält. Als neutrale Faser wird diejenige Faser oder Schicht eines Balkenquerschnitts bezeichnet, deren Länge sich bei Biegen oder Torsion des Balkens nicht ändert. Insbesondere ist die neutrale Faser der Ort, an dem sich bei Biegen oder Torsion Zug- und Druckspannung genau die Waage halten. Von der Form können formbezogene Kenngrößen abgeleitet werden, beispielsweise Warp als Differenz der größten und der geringsten Abweichung der Mittelfläche von der Ausgleichsebene (regression plane) oder der Bow als Abweichung des Scheitelpunkts des Ausgleichs-Rotationsparaboloids der Mittelfläche von der Ausgleichsebene (mit Vorzeichen) oder die Welligkeit (Waviness) als räumlich Hochpass-gefilterte Wiedergabe der Mittelfläche. Ein eindeutiger Welligkeitsverlauf erfordert daher immer die Angabe der räumlichen Grenzfrequenz, Güte und Filterordnung, mit der die räumliche Tiefpassfilterung vorgenommen wird. Die Ausgleichsebene wird gebildet nach der Methode der kleinsten Quadrate.

Sowohl beim Drahttrennläppen als auch beim Drahttrennschleifen erfolgt der jeweilige Materialabtrag lokal nach Abtragsrate, erzeugter Rauigkeit und Oberflächenschädigung statistisch verteilt. Die Hauptflächen der durch den Trennvorgang entstehenden Scheiben weisen somit in zueinander korrespondierenden Orten an Vorder- und Rückseite der Scheiben statistisch nach Häufigkeit, Tiefe und Art verschieden verteilte Oberflächendefekte auf. Von jedem Defekt geht eine Verspannung aus. Das wird beispielsweise auch in der JP 08 274 050 A thematisiert. Unterschiedliche Verspannungen korrespondierender Bereiche in Vorder- und Rückseite der Scheiben führen zu resultierenden, verbleibenden lateralen Schubspannungen in der Scheibenoberfläche, die die Scheibe elastisch verkrümmen. Diese elastische Verformung der Scheibe wird als spannungsinduzierte Verformung (strain-induced warpage) bezeichnet.

Vorder- und Rückseite eines zu Beginn der Bearbeitung mittels DDG elastisch verkrümmten Wafers sind am Ende der Bearbeitung zwar planparallel zueinander, der Wafer bleibt jedoch weiterhin elastisch verspannt. Der Wafer entspannt sich nach dem Entfernen aus den Wasserkissen und weist dann zwar eine homogene Dicke, jedoch eine nicht-ebene Form auf. Derartige Wafer sind für anspruchsvolle Anwendungen ungeeignet.

Die Ebenheit eines Wafers leidet auch aufgrund von Unterschieden in der strukturellen Beschaffenheit (Rauigkeit) und/oder kristallinen Beschaffenheit (Risse, Mosaike, Versetzungen) von Vorder- und Rückseite. Die Unterschiede ziehen unterschiedliche Materialabträge während der Bearbeitung mittels DDG nach sich mit dem Ergebnis, dass der Wafer während der Schleifbearbeitung einseitig aus der Mittelfläche zwischen den Wasserkissen axial herausgedrückt und somit nicht mehr axial zwangskräftefrei bearbeitet wird.

Es sind verschiedene Prozessabfolgen bekannt, die darauf abzielen, Wafer mit möglichst ebener Form bereitzustellen. US 2002/0016072 A1 und US 6,376,395 B2 beschreiben Abfolgen, die auch ein simultanes doppelseitiges Läppen umfassen. Das zusätzliche Läppen macht diese Abfolgen unwirtschaftlich.

Die US 6,491,836 B1, US 6,376,335 B1 und US 6,066,565 beschreiben ähnlich unwirtschaftliche Abfolgen.

US 2006/0252272 A1 beschreibt eine Prozessabfolge aus (a) Sägen, (b) Kantenverrunden und (c) Läppen, wobei der Wafer nach dem Kantenverrunden alkalisch gereinigt wird.

Es ist generell zu unterscheiden zwischen Reinigen und Ätzen: Eine Reinigung entfernt Fremdstoffe von der Werkstückoberfläche, ohne die Werkstückoberfläche selbst zu beschädigen oder zu modifizieren. Bei einer Reinigung erfolgt also kein Materialabtrag vom Werkstück selbst, und es werden insbesondere Dicke und Form des Werkstücks nicht verändert. Bei einem Ätzen erfolgt hingegen ein Materialabtrag vom Werkstück.

US 2009/0203212 A1 beschreibt eine Prozessabfolge aus Sägen und Schleifen, wobei vor dem Schleifen eine Reinigung vorgenommen wird, die Schwermetalle von der Oberfläche der gesägten Scheibe entfernen soll. Dafür wird auch eine RCA SC1-Reinigung mit Ammoniak (NH₄OH) und Wasserstoffperoxid (H₂O₂) bei erhöhter Temperatur (60 °C bis 90 °C) vorgeschlagen.

### Aufgabe

Die Aufgabe der vorliegenden Erfindung besteht darin, ein wirtschaftliches Verfahren bereitzustellen, das Wafer mit besonders hohem Grad an Planparallelität ihrer Vorder- und Rückseiten und Armut an kristallinen und strukturellen Defekten ihrer Oberflächen liefert.

### Lösung

Die Aufgabe wird gelöst durch ein Verfahren zur Herstellung von Scheiben aus einem zylindrischen Stab aus Halbleitermaterial mit einer Achse und einer Kennkerbe in der Mantelfläche des Stabs und parallel zur Achse, umfassend in der angegebenen Reihenfolge
(a) das gleichzeitige Abtrennen einer Vielzahl von Scheiben vom zylindrischen Stab mittels Drahtsägen in Gegenwart eines Schneidmittels;
(b) das Ätzen der Scheiben mit einem alkalischen Ätzmittel in einem Ätzbad bei einer Temperatur von 20 °C bis 50 °C und während einer Verweildauer, wobei weniger als 5/1000 einer anfänglichen Scheibendicke als Materialabtrag von jeder der Scheiben entfernt wird; und
(c) das Schleifen der Scheiben mittels simultanem Doppelseitenschleifen mit einem ringförmigen Schleifbelag als Werkzeug.

Das Schleifen der Scheiben mittels DDG ist die erste mechanische Bearbeitung der Vorder- und Rückseite der Scheiben nach dem gleichzeitigen Abtrennen der Scheiben vom zylindrischen Stab.

Beim Drahtsägen wird Draht um mindestens zwei zylinderförmige Drahtführungsrollen mit parallel zueinander angeordneten Achsen spiralförmig so herumgeführt, dass zwischen zwei benachbarten Drahtführungsrollen ein dem Stab zugewandtes ebenes Gatter aus parallel zueinander und senkrecht zu den Achsen der Drahtführungsrollen verlaufenden Abschnitten des Drahts gebildet wird. Der Stab wird mittels einer Zustellvorrichtung senkrecht so auf das Drahtgatter zugestellt, dass er in Kontakt mit dem Drahtgatter gelangt, und die Drahtabschnitte sich bei fortgesetzter Zustellung, Relativbewegung zum Stab mittels gleichsinniger Drehung der Drahtführungsrollen um ihre Achsen und in Anwesenheit eines abrasiv wirkenden Schneidmittels Material abtragend durch den Stab hindurcharbeiten.

Beim simultanen Doppelseitenschleifen wird die Scheibe in einem rotierenden Haltering mit einem Mitnehmerstift, der in die Kennkerbe der Scheibe eingreift, radial geführt und gedreht sowie zwischen zwei Wasserkissen axial geführt. Gleichzeitig werden gegenläufig rotierende, kollinear zueinander angeordnete Topfschleifscheiben mit Achsen parallel zur Achse der Scheibe und mit jeweils einem ringförmigen Schleifbelag auf die Mittelebene zwischen den zwei Wasserkissen zugestellt, so dass ein scheibenvorder- und rückseitig simultaner Materialabtrag erfolgt.

Das Ätzen kann in einem Ätzbad durchgeführt werden, in dem eine oder mehrere der folgenden Verbindungen gelöst sind: Kaliumhydroxid (KOH), Natriumhydroxid (NaOH), Ammoniumhydroxid (NH₄OH) und/oder Tetramethylammoniumhydroxid (TMAH, N(CH₃)₄OH) enthalten. Ein Oxidationsmittel wie Wasserstoffperoxid ist nicht Bestandteil des alkalischen Ätzmittels, weil es den Materialabtrag von der Oberfläche des Wafers behindert. Die Konzentration des alkalischen Ätzmittels kann 0,5 bis 10 Gew.-% betragen, bevorzugt 1 bis 5 Gew.-%. Die Temperatur kann von 20 °C bis 50 °C betragen, bevorzugt 25 bis 40 °C. Die Verweildauer der Wafer im Ätzbad kann 0,5 min bis 15 min betragen, bevorzugt 1 min bis 6 min.

Das Drahtsägen kann ein Drahttrennläppen sein, der Draht dabei aus hypereutektischem Stahl (Pianodraht) mit einem Kohlenstoffgehalt von 0,8 Gew.-% bis 1 Gew.-% bestehen und einen Durchmesser von 50 µm bis 175 µm aufweisen. Das abrasiv wirkende Schneidmittel ist vorzugsweise eine Aufschlämmung von Siliciumcarbid (SiC) mit einer Korngröße von 7 µm bis 13 µm in Glycol oder Öl. Der Draht kann ein Glattdraht oder ein strukturierter Draht sein. Das Drahtsägen kann auch als Drahttrennschleifen ausgeführt werden, wobei als Draht ein hypereutektoider Stahldraht mit einem Kohlenstoffgehalt von 0,8 Gew.-% bis 1 Gew.-% und mit einem Durchmesser von 50 µm bis 120 µm eingesetzt wird. Das Schneidmittel sind vorzugsweise Diamanten mit einer Korngröße von 4 µm bis 20 µm, die in der Oberfläche des Drahts verankert sind, beispielsweise mittels galvanischer Bindung mit Nickel, mittels Kunstharzbindung oder mechanisch, beispielsweise durch formschlüssiges Einpressen/Einrollen in die Oberfläche des Drahts.

Das Drahtsägen kann mit unidirektionaler Drahtbewegung oder unter Umkehrung der Richtung der Drahtbewegung erfolgen. Bevorzugt ist ein Drahtsägen nach dem Pilgerschritt-Verfahren (pilgrim mode slicing, wire-reciprocating slicing), wobei der Draht in einer Vielzahl von Paaren von Richtungsumkehrungen um Drahtführungsrollen bewegt wird, und wobei ein Paar von Richtungsumkehrungen jeweils ein Bewegen um eine erste Länge in eine erste Drahtlängsrichtung und ein nachfolgendes Bewegen um eine zweite Länge in eine zweite, der ersten Drahtlängsrichtung genau entgegengesetzte Richtung umfasst, und die erste Länge größer als die zweite Länge gewählt wird.

Die Schleifmittel in den Topfschleifscheiben beim simultanen Doppelseiten-Schleifen (DDG) können keramisch, mit Kunstharz oder metallisch gebunden sein. Bevorzugt ist eine keramische Bindung. Die mittlere Korngröße der Schleifmittel beim DDG kann 0,5 µm bis 12 µm betragen, bevorzugt 1,5 µm bis 6 µm.

### Ausführliche Erfindungsbeschreibung

Die Erfindung wird nachfolgend ausführlich anhand von Abbildungen, Beispielen und Vergleichsbeispielen beschrieben.

Kurzbeschreibung der Abbildungen
- Fig. 1: Elemente einer Drahtsäge
- Fig. 2: Elemente einer Vorrichtung zum simultanen Doppelseitenschleifen
- Fig. 3: Diagramm mit Dicken- und Form- und Welligkeitsverlauf einer Scheibe (A) Vergleichsbeispiel: nach Drahtsägen (ohne Ätzen) (B) Beispiel: nach Drahtsägen und nachfolgendem Ätzen
- Fig. 4: Diagramm der maximalen Spindelströme während der DDG-Bearbeitung von Scheiben

### Liste der Bezugszeichen und Abkürzungen

- 1: Draht
- 2: Drahtabschnitt
- 3: linke Drahtführungsrolle
- 4: rechte Drahtführungsrolle
- 5: Achse der linken Drahtführungsrolle
- 6: Achse der rechten Drahtführungsrolle
- 7: Drehrichtung der linken Drahtführungsrolle
- 8: Drehrichtung der rechten Drahtführungsrolle
- 9: Drahtzufuhr
- 10: Drahtabfuhr
- 11: Drahtgatter
- 12: Werkstück
- 13: Bewegung des Drahtgatters
- 14: Achse des Werkstücks
- 15: Sägeleiste
- 16: Klebefuge
- 17: Zustellrichtung des Werkstücks auf das Drahtgatter zu
- 18: Rille
- 19: linke Schneidflüssigkeitsdüse
- 20: rechte Schneidflüssigkeitsdüse
- 21: Austrittsöffnungen für Schneidflüssigkeit
- 22: linker Strahl
- 23: rechter Strahl
- 24: Primärspanfläche
- 25: Trennspalt
- 26: Kennkerbe
- 27: verschleißresistente Beschichtung
- 28: linke Schleifspindel
- 29: rechte Schleifspindel
- 30: Drehrichtung der linken Spindel
- 31: Drehrichtung der rechten Spindel
- 32: linkes Topfschleifrad
- 33: rechtes Topfschleifrad
- 34: Schleifzähne
- 35: linkes Wasserkissen
- 36: rechtes Wasserkissen
- 37: Rückseite
- 38: Carrier Ring
- 39: Führungsring
- 40: Drehrichtung des Carrier-Ring-Antriebs
- 41: Drehrichtung des Carrier Rings
- 42: Mitnehmerstift
- 43: Scheibe
- 44: linke Spindelachse
- 45: rechte Spindelachse
- 46: Dickenverlauf
- 47: Formverlauf
- 48: Verlauf der Welligkeit einer Scheibe über die Schnitttiefe nach Drahtsägen
- 49: Dickenverlauf
- 50: Formverlauf
- 51: Verlauf der Welligkeit
- 52: Kurve
- 53: Kurve
- 54: Bereich
- 55: Bereich
- 56: Bereich
- 57: Punkt
- 58: Punkt
- 59: Antriebsrollen für Carrier Ring
- 60: Bohrung der Hohlspindel
- 61: Unterschied
- DDG: simultanes Doppelseitenschleifen (Double-Disk Grinding)
- DMWS: Drahttrennschleifen (Diamond (wire) MWS)
- DOC: Schnitttiefe (Depth Of Cut)
- ETCH: Ätzen (alkalisch oder sauer)
- LMC: maximale Stromaufnahme der linken Schleifspindel (Left Max Current)
- MWS: Drahtsägen (Multi-Wire Slicing)
- RMC: maximale Stromaufnahme der rechten Schleifspindel (Right Max Current)
- SHP: Form (SHaPe) der Scheibe
- SMWS: Drahttrennläppen (Slurry-MWS)
- THK: Dicke (THicKness) der Scheibe
- WAV: Welligkeit (WAViness) der Scheibe

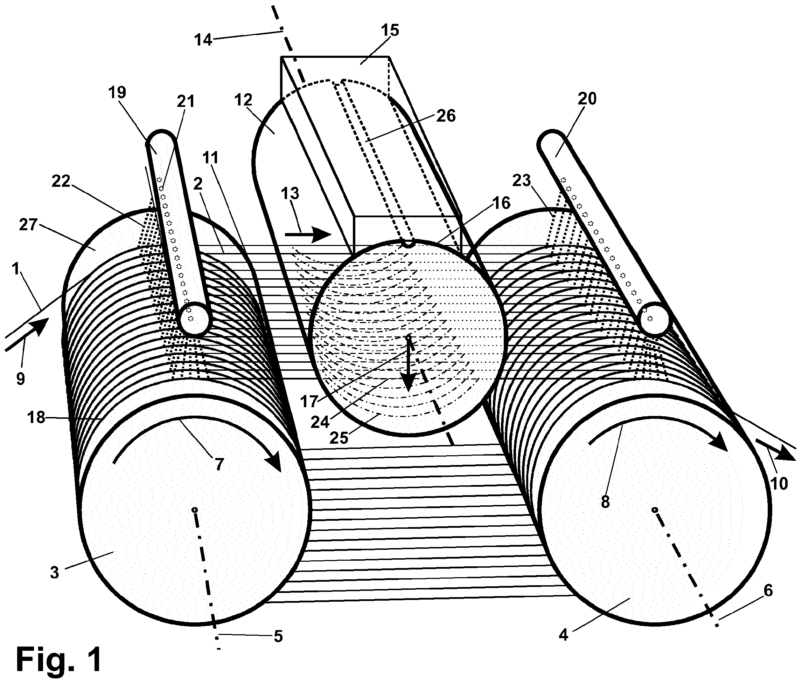

Fig. 1 zeigt Elemente einer Drahtsäge, die für das Verständnis des erfindungsgemäßen Verfahrens von Bedeutung sind. Draht 1 wird aus einem Vorrat (Frischdrahtspule, nicht gezeigt) in Bewegungsrichtung 9 dem aus parallel zueinander verlaufenden Abschnitten 2 des Drahtes zwischen zwei Drahtführungsrollen 3 und 4 aufgespannten Gatters 11 zugeführt. Das Drahtgatter 11 wird dadurch gebildet, dass der Draht spiralförmig in Rillen 18 in der verschleißfesten Beschichtung 27 um die Drahtführungsrollen herumgeführt wird. Die Rillen 18 sind jeweils geschlossen und verlaufen parallel und in im Wesentlichen paarweise konstanten Abständen zueinander in Ebenen senkrecht zu den Achsen 5 und 6 der Drahtführungsrollen 3 und 4. Nach Durchlaufen des Drahtgatters 11 verlässt der Draht das Drahtgatter in Bewegungsrichtung 10 und wird einem Vorrat zugeführt (Altdrahtspule, nicht gezeigt).

Durch gleichsinniges Drehen 7 und 8 der Drahtführungsrollen 3 und 4 um ihre Achsen 5 und 6 werden die parallel zueinander verlaufenden Drahtabschnitte 2 des Drahtgatters 11 relativ zu dem Werkstück 12 in Richtung 13 bewegt. Das Werkstück 12, ein zylindrischer Stab aus Halbleitermaterial mit einer Achse 14, ist mit einer Sägeleiste 15 durch eine Klebefuge 16 verbunden und wird mit einer Zustellvorrichtung (nicht gezeigt) in Richtung 17 auf das Drahtgatter zugestellt. Die Achse 14 und die Achsen 5 und 6 von linker Drahtführungsrolle 3 und rechter Drahtführungsrolle 4 sind parallel zueinander ausgerichtet. Für den Fall, dass sog. fehlgeneigte (fehlorientierte) Wafer benötigt werden, kann die Achse 14 auch gegenüber den Achsen der Drahtführungsrollen verkippt sein. Das Werkstück 12 ist in seiner Mantelfläche mit einer radial auf die Achse 14 weisenden und parallel zur Achse 14 verlaufenden Kennkerbe 26 (Notch) versehen.

Das Drahtgatter 11 wird auf der Seite des Werkstücks 12, von der sich das Gatter in Richtung 13 auf das Werkstück zubewegt, mittels einer Düse 19 durch Austrittsöffnungen 21 mit einem Strahl 22 von Schneidmittel beaufschlagt. Beim Drahtsägen nach dem Drahttrennläppverfahren ist der Draht 1 ein glatter oder ein strukturierter Pianodraht, dessen Oberfläche zunächst selbst keine abrasiv wirkenden Stoffe enthält, und das Schneidmittel ist eine Aufschlämmung freier abrasiv wirkender Stoffe. Beim Drahtsägen nach dem Drahttrennschleifverfahren ist der Draht 1 ein glatter Pianodraht, in dessen Oberfläche abrasiv wirkende Stoffe als Schneidmittel fixiert sind, und der Strahl 22 besteht aus einer Schneidflüssigkeit, die selbst keine abrasiv wirkenden Stoffe enthält. Beim Drahtsägen mit bidirektionaler Drahtbewegung, z.B. nach dem Pilgerschrittverfahren, wird der Draht wechselseitig in Richtung 13 auf das Werkstück zu bewegt. In diesem Fall ist neben einer Düse 19 auch eine ihr gegenüberliegende Düse 20 vorhanden, die das Drahtgatter mit einem Strahl 23 aus Schneidmittel beziehungsweise Schneidflüssigkeit beaufschlagt. Beim Pilgerschrittverfahren können die Düsen 19 und 20, je nach Bewegungsrichtung 13 des Drahtgatters 11, alternierend oder kontinuierlich betrieben werden. Bevorzugt ist ein kontinuierlicher Betrieb.

Durch Zustellung des Werkstücks 12 in Richtung 17 senkrecht auf das Drahtgatter 11 zu wird das Werkstück zunächst in Kontakt mit dem Drahtgatter gebracht. Bei fortgesetzter Zustellung des Werkstücks unter Anwesenheit von Schneidmittel und Relativbewegung der Drahtabschnitte 2 des Drahtgatters relativ zum Werkstück bewirken die Drahtabschnitte einen Materialabtrag vom Werkstück 12. Im Einzelnen bewirkt die Zustellung dabei zunächst eine geringe Durchbiegung der Drahtabschnitte in Zustellrichtung 17 (in Fig. 1 nicht gezeigt), so dass die aus der Elastizität des Drahts resultierenden Rückstellkräfte eine Kraft der Drahtabschnitte entgegengesetzt zur Zustellrichtung auf die Primärspanfläche 24 ausüben. Diese Kraft lässt die sich zwischen Draht und Werkstück befindlichen abrasive wirkenden Feststoffe in das Werkstückmaterial eindringen, und die Relativbewegung von Draht zu Werkstück bewirkt dann das Lösen von Spänen aus dem Werkstückmaterial und somit den Materialabtrag. Jeder Drahtabschnitt bildet so einen Trennspalt 25 aus. Der Trennvorgang ist beendet, wenn sich das Drahtgatter 11 vollständig durch das Werkstück 12 hindurchgearbeitet hat und vollständig in der Sägeleiste 15 zu liegen gekommen ist. Die Distanz zwischen dem Punkt des ersten Kontakts des Drahtgatters mit dem Werkstück (Einschnitt, cut-in) und der Hauptspanfläche 24 wird als Schnitttiefe bezeichnet.

Nach dem Drahtsägen werden die entstandenen Scheiben von Resten der Sägeleiste 15 und der Klebefuge 16 getrennt.

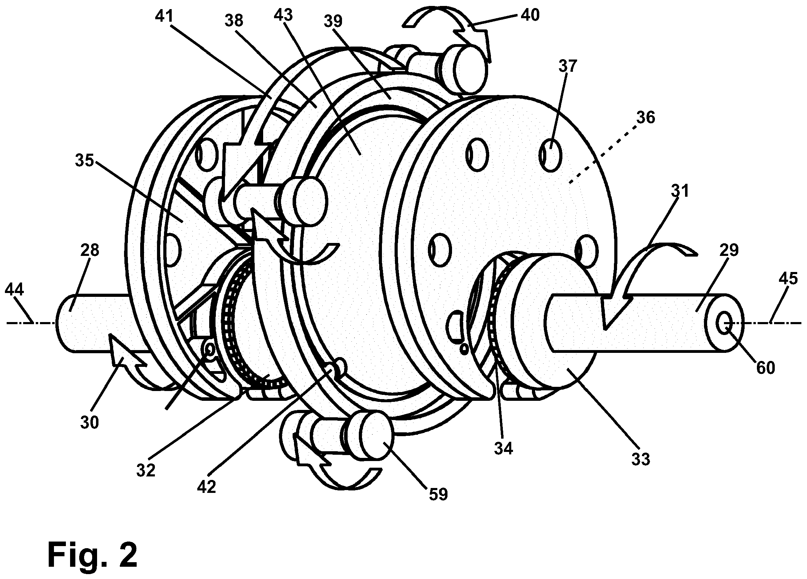

Fig. 2 zeigt Elemente einer Vorrichtung zum simultanen Doppelseitenschleifen (DDG) in Explosionsdarstellung, die für das Verständnis des erfindungsgemäßen Verfahrens von Bedeutung sind. Die zu bearbeitende Scheibe 43 (Wafer) liegt in einem Carrier Ring 38 als Aufnahme. Im Carrier Ring 38 ist ein Führungsring 39 eingespannt, dessen Dicke geringer ist als die Zieldicke der Scheibe nach DDG-Bearbeitung. Der Führungsring weist einen Mitnehmerstift 42 auf, der in die Kennkerbe der Scheibe 43 eingreift. Der Carrier Ring 38 wird radial von Rollen 59 geführt, die in Richtung 40 rotieren und dadurch den Carrier Ring 38 in Rotation 41 um seine Mittelachse versetzen. Der Mitnehmerstift 42 überträgt diese Rotation 41 über die Kennkerbe auf die Scheibe. Die Scheibe 43 ist mit einem Radialspiel lose in den Führungsring 39 des Carrier Rings 38 eingelegt, so dass keine radialen Zwangskräfte auf die Scheibe ausgeübt werden, die die Scheibe elastisch verformen könnten. Eine linke 28 und rechte Schleifspindel 29, deren Achsen 44 und 45 kollinear zueinander und parallel zur Mittelachse der Scheibe ausgerichtet sind, tragen eine linke 32 und eine rechte Topfschleifscheibe 33 mit jeweils einem Ring aus Schleifzähnen 34, von denen eine der Vorder- und die andere der Rückseite der Scheibe 43 zugewandt ist. Die Achsen 44 und 45 der Spindeln sind um den Betrag des Außenradius' der Ringe aus Schleifzähnen 43 gegenüber der Mittelachse der Scheibe 43 verschoben, dass der Außenrand des Schleifzahn-Rings durch die Mittelachse der Scheibe verläuft.

Axial wird die Scheibe 43 zwischen zwei Wasserkissen 35 und 36 hydrostatisch gelagert, wobei eines der Scheibenvorder- und das andere der Scheibenrückseite zugewandt ist. Solange die Mittelfläche der Scheibe näherungsweise mit deren Ausgleichsebene identisch ist, d.h. die Scheibe keine starke Verkrümmung oder Welligkeit aufweist, verläuft die Mittelfläche daher koplanar zur Mittelebene zwischen den Wasserkissen. Die Wasserkissen üben dann keine axialen Zwangskräfte auf die Scheibe aus, und die Scheibe wird nicht axial elastisch verformt. Zur DDG-Bearbeitung werden die rotierenden Schleifspindeln 28 und 29 unter fortgesetzter Rotation der Scheibe durch den angetriebenen Carrier Ring 39 symmetrisch auf die Mittelebene zwischen den Wasserkissen 35 und 36 und somit symmetrisch auf die Mittelfläche der Scheibe 43 zugestellt, so dass die Schleifzähne 34 bei Kontakt der Topfschleifräder mit der Scheibe einen simultan beidseitigen Materialabtrag von der Scheibe 43 bewirken. Die Zuführung von Wasser zu den Wasserkissen erfolgt von der jeweiligen Rückseite 37 der Wasserkissen aus.

Im ersten Kontakt der Topfschleifräder mit der Scheibe erzeugen die Topfschleifräder zunächst einen ringförmigen Materialabtrag von der Scheibe, wobei sich dieser ringförmige Abtrag vom Scheibenzentrum bis zum Scheibenrand erstreckt. Der Durchmesser der Topfschleifräder ist etwas größer als der Radius der Scheibe, so dass die Topfschleifräder etwas über den Rand der Scheibe überlaufen und so das abgetragene Material aus der Materialabtragszone abgeführt werden kann. Die Schleifspindeln sind als Hohlspindeln ausgeführt. Mittels zweier Flüssigkeits-Drehdurchführungen (nicht gezeigt) wird den Topfschleifrädern Wasser durch die Bohrungen 60 der Hohlspindeln zugeführt, das als Kühlschmiermittel die Material abtragenden Schleifzähne 34 kühlt und das von der Scheibe abgetragene Material abtransportiert. DDG ist ein sog. Subapertur-Verfahren, da zu jedem Zeitpunkt das Werkzeug nur einen Teil der Scheibenoberfläche bedeckt. Erst durch Rotation der Scheibe mittels des Carrier Rings zwischen den Topfschleifscheiben hindurch wird sukzessive die gesamte Waferoberfläche überstrichen und bearbeitet. Da die Scheibenoberfläche während der Bearbeitung zugänglich ist, kann die momentane Dicke der Scheibe 43 beispielsweise mittels eines am Außenumfang der Scheibe eingreifenden beidseitigen Tasters (caliper gauge, nicht gezeigt) fortlaufend in situ gemessen werden.

Bei Erreichen einer Zieldicke wird der beidseitige Taster ausgeschwenkt, die weitere Zustellung der Schleifspindeln beendet und die Scheibe unter den weiterhin rotierenden Topfschleifscheiben hindurch rotiert. Dadurch wird der spiralförmig um die Scheibe umlaufende und axial in die Scheibe hinein verlaufende Materialabtrag in einen für die gesamte Oberfläche der Scheibe planaren Materialabtrag überführt. Die Schubkräfte aufgrund der Spindelzustellung, die für einen Material abtragenden Eingriff in das Werkstück erforderlich sind, bauen sich langsam ab, und die aus Diamanten bestehenden Schleifkörner der Topfschleifscheiben geraten aus dem Eingriff in das Werkstück. Dieser Vorgang wird als Ausfeuern (spark out) bezeichnet. Dabei werden auch eventuelle Spuren des beidseitigen Tasters beseitigt. Da die Topfschleifräder am Ende des Ausfeuerns mit dem gesamten Umfang ihrer Schleifzahnringe plan auf der dann ebenen Oberfläche der Scheibe aufliegen, bildet sich ein Kreuzschliffmuster auf beiden Seiten der Scheibe aus.

Dem Zustandekommen der Erfindung liegen eine Reihe von Beobachtungen und Versuche zugrunde, die im Folgenden aufgeführt werden:
Erstens wurde per Elementanalyse beobachtet, dass die Oberfläche von Scheiben aus einkristallinem Silicium (Wafer) nach Drahttrennläppen eine Konzentration von Kupfer aus dem Abrieb der Messingbeschichtung des Sägedrahts aufweist, die die maximale Volumenlöslichkeit von Kupfer in einkristallinem Silicium bei Raumtemperatur deutlich übersteigt. Eine Tiefenprofilanalyse zeigte, dass das Kupfer nur in einer wenige Mikrometer dicken Schicht vorliegt. Daraus, dass sich im unter der geschädigten Oberfläche des Wafers liegenden Volumen nach Drahtsägen keine erhöhte Kupferkonzentration nachweisen ließ, schlossen die Erfinder, dass die geschädigte Oberfläche des drahtgesägten Wafers als Fangstoff (Getter) wirkt, der die Mobilität des Kupfers reduziert und ein Eindringen in das kristallin ungeschädigte Volumen des Wafers verhindert.

Zweitens wurde beobachtet, dass der Warp unmittelbar nach Drahtsägen wesentlich größer ist als die Summe aus dem Warp nach weiterer Material abtragender Bearbeitung und dem aus Erfahrung bekannten Maß an Verringerung des Warps durch diese Material abtragende Bearbeitung. Es wurde daraus geschlossen, dass der Wafer unmittelbar nach Drahtsägen zusätzlich zu seiner plastischen Verformung durch unebenen Schnittverlauf einen großen Anteil elastischer Verformung aufweist, die durch Vorder-/Rückseiten-asymmetrische Rauigkeit oder kristalline Schädigung verursacht wird. Die Gesamtheit aller oberflächennahen Kristallstörungen wird als Sub-Surface Damage bezeichnet. Die elastisch spannungsinduzierte Verspannung aufgrund von Sub-Surface Damage wird auch Strain-Induced Warpage genannt.

Zur weiter Material abtragenden Bearbeitung wurde ein 2-minütiges Ätzen in 4 Gew.-%iger Kalilauge bei 40 °C gewählt. Der Materialabtrag wurde aus der Differenz der Wägung des Wafers vor und nach dem Ätzabtrag in einer Präzisionswaage bestimmt, und ergab eine plausible Dickenabnahme durch die Ätzbehandlung.

Drittens wurde eine erhöhte Kupferkonzentration im Volumen geätzter Wafer beobachtet, wenn die das Eindringen von Kupfer ins Volumen verhindernde, als Getter wirkende, geschädigte Oberflächenschicht weitgehend abgetragen worden war.

Viertens wurde beobachtet, dass die elastisch spannungsinduzierte Verspannung bereits bei sehr geringen Ätzabträgen wesentlich reduziert werden konnte. Es wurden Bedingungen für den Materialabtrag ermittelt, bei denen die durch Drahtsägen elastisch spannungsinduzierte Verspannung wirksam beseitigt werden konnte, ohne die verbliebene noch geschädigte Schicht, die ein Eindringen von Kupfer ins Volumen der Halbleiterscheibe verhindert, vollständig abzutragen. Fünftens wurde beobachtet, dass ein durch Ätzen unter diesen Bedingungen verspannungs-reduzierter Wafer nach nachfolgender DDG-Bearbeitung einen wesentlich geringeren Warp aufweist als ein Wafer, der nicht geätzt wurde. Dazu wurden Wafer aus derselben Drahtsägefahrt, die im Wesentlichen gleiche Warp-Werte wie gesägt aufwiesen, teilweise geätzt und teilweise unbehandelt gelassen und danach DDG-geschliffen und der Warp erneut gemessen.

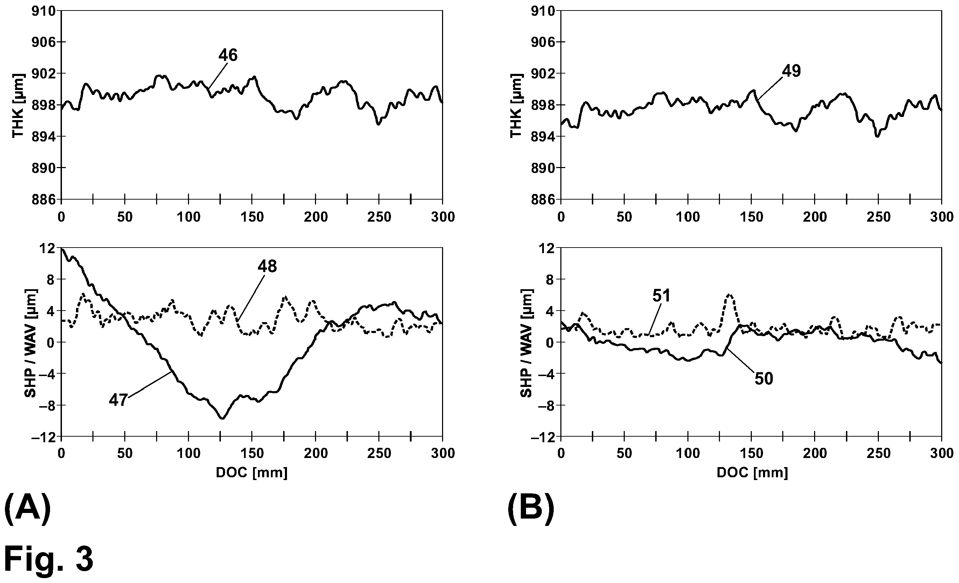

Fig. 3 zeigt den Dickenverlauf 46 und 49 (obere Diagramme, THK = Dicke) und den Formverlauf 47 und 50 (untere Diagramme, SHP = Form) eines 300 mm-Wafers nach Drahttrennläppen über die Schnitttiefe, (A) vor und (B) nach Ätzen (identischer Wafer). Vor dem Ätzen weist der Wafer einen deutlich verspannten Formverlauf 47 entlang eines Linearscans in Schnittrichtung auf. Der Linear Shape Range (LSR, Minimum bis Maximum der Verformung) beträgt etwa 22 µm. Nach Ätzen ist der LSR auf etwa 4 µm entsprechend dem Formverlauf 50 gesunken. Die Differenz des Dickenverlaufs 46 und 49 entspricht einem Materialabtrag von 1 - 2 µm. Die Gesamtdicke des Wafers betrug im Mittel 895 µm. Die relative Dickenabnahme betrug demnach nur 1,5/895 ≈ 1,7 %o. Das Ätzen fand durch 4-minütiges Eintauchen des Wafers in 4 Gew.-%ige Kaliumhydroxidlösung bei 40 °C statt. Dabei wurde die ersten 30 s kein nennenswerter Materialabtrag beobachtet (keine Bildung von H₂-Gasblasen), da zunächst natürliches Oxid (native oxide) mit geringerer Ätzrate abgetragen wird. Ein gewünschter Materialabtrag lässt sich mittels der Konzentration des Ätzmittels, der Temperatur des Ätzbads und der Verweildauer des Wafers im Ätzbad genau einstellen.

Fig. 3 zeigt auch den Welligkeitsverlauf 48 und 51 (untere Diagramme, WAV = Welligkeit) des Wafers unmittelbar nach Drahttrennläppen (A) und nach zusätzlicher Ätzbehandlung (B). Die Welligkeit WAV wurde ermittelt, indem für jede Schnitttiefe (depth of cut, DOC) die Differenz aus Maximum und Minimum des jeweiligen Formverlaufs innerhalb eines 10 mm langen Messfensters entlang der Schnitttiefe bestimmt wurde und die Ergebnisse als Welligkeit WAV = |f(SHP)| gegen den Anfangspunkt des Messfensters auf der Schnitttiefenachse aufgetragen wurde. Für eine gegen Null (statt 10 mm) gehende Breite des Bereichs, in dem die Differenz aus Max und Min bestimmt werden, entspräche die Welligkeit WAV der ersten Ableitung des Formverlaufs nach dem Ort. Die angegebene Messvorschrift für die Welligkeit WAV entspricht einer räumlichen Hochpass-Filterung des Formverlaufs mit einer räumlichen Eckfrequenz f0 = 1/10mm. Da WAV im Ortsraum mittels "Boxcar" (hartes Abschneiden der außerhalb liegenden Werte) ermittelt wird, entspricht es im (Orts)-frequenzraum einem Kammfilter sehr hoher Güte und Ordnung. (Wenn zusätzlich Werte außerhalb der Boxcar-Grenzen mit abnehmender Gewichtung berücksichtigt werden, reduzieren sich die Filterordnung und -güte in Abhängigkeit von der Funktion, mit der diese abnehmende Gewichtung von out-of-band-Werten vorgenommen wird.)

Ungeachtet des erfindungsgemäßen Ätzens der Scheibe vor deren Bearbeitung mittels DDG sollte die nach Drahtsägen kristallin geschädigte Oberflächenschicht noch soweit erhalten bleiben, dass die noch bestehende Getter-Wirkung ein Diffundieren von Kupfer ins Volumen des Wafers wirksam verhindert. Das kann als gegeben betrachtet werden, wenn der Abtrag nicht mehr als 5/1000 der ursprünglichen Dicke beträgt, was bei einer Dicke von 895 µm einem Materialabtrag von 4,5 µm entspricht. Der Ätzabtrag sollte andererseits auch hoch genug sein, um die elastische Verspannung des Wafers aufgrund lokaler Vorder-/Rückseiten-Asymmetrien in der Rauigkeit und dem Grad und der Tiefe der kristallinen Schädigung auszugleichen.

Die Dicke und Beschaffenheit (Stöchiometrie, Dichte) des natürlichen Oxids und somit die genaue Dauer der Initialzeit der Ätze hängen von der genauen Wartezeit zwischen dem Sägen, also dem Erzeugen der Oberfläche des Wafers und dem Ätzen, den dabei herrschenden Umgebungsbedingungen (Temperatur, Luftfeuchte), dem Grad der Schädigung (Verspannung des Silicium-Kristallgitters) und der Dotierung (Abschirmung der Ladungsverteilung der Silicium-Bindungen) ab und beträgt maximal etwa 2 nm. Die Wafer sollten vorzugsweise über ihre gesamte Oberfläche gleichförmig geätzt werden, d.h. die Zeit zum Eintauchen in und zum Entnehmen aus der Ätze sollte möglichst kurz gegen die gesamte Verweildauer in der Ätze sein. Der Materialabtrag der durch das Ätzen der Scheiben mit dem alkalischen Ätzmittel erzielt wird, beträgt vorzugsweise mindestens 0,3 µm je Scheibe, vorzugsweise mindestens 0,5 µm je Scheibe. Für einige elastisch verspannungs-induziert verformte Wafer reichten 0,5 µm Materialabtrag bereits aus, um eine wesentliche elastische Entspannung zu erreichen.

Wegen der im Silicium-Festkörper mit der Temperatur zunehmenden Diffusionsgeschwindigkeit von Verunreinigungen, insbesondere von Kupfer, sollte die Temperatur des Ätzbads nicht mehr als 50 °C betragen.

Sechstens wurde beobachtet, dass das Ätzen mit alkalischem Ätzmittel, beispielsweise Kaliumhydroxid, besser geeignet ist als ein Ätzen mit saurem Ätzmittel, beispielsweise Salpetersäure. Das Ätzen mit alkalischem Ätzmittel wirkt anisotrop, das Ätzen mit saurem Ätzmittel isotrop. Das Ätzen mit alkalischem Ätzmittel erzeugt auf (100)-orientierten Oberflächen aus Silicium kleine vierseitige Pyramiden, die die Oberfläche eines Wafers aufrauen und diese dem DDG-Schleifrad als reproduzierbare Oberfläche für den Eingriff zur Verfügung stellen.

Siebtens wurde beobachtet, dass beim Schleifen einer Scheibe mittels DDG die Topfschleifräder in der Regel einen asymmetrischen Materialabtrag von Vorder- und Rückseite des Wafers bewirken, wenn zuvor auf das Ätzen mit alkalischem Ätzmittel verzichtet wird. Die Asymmetrie kann derart ausgeprägt sein, dass nur ein Schleifrad einen Abtrag verursacht und das gegenüberliegende Schleifrad praktisch abtragsfrei über die Oberfläche des Wafers gleitet. Der Grad der Asymmetrie des Materialabtrags kann beispielsweise beobachtet werden, indem Wafer mit Lasermarkierung einmal auf der Vorderseite und einmal auf der Rückseite durch zwischenzeitliches Umdrehen des Wafers mittels DDG geschliffen werden. Ist die Lasermarkierung als Deepmark ausgeführt worden, liegen die Punkte der Lasermarkierung etwa 100 µm tief, also tiefer als es dem Materialabtrag von beispielsweise 70 µm entspricht, der beim Schleifen mittels DDG auf beiden Seiten insgesamt entsteht. Dies macht die Tiefenmessung der Punkte der Lasermarkierung gut geeignet für eine seitenaufgelöste Messung des Materialabtrags. Bei den gewählten Schleifscheiben und kinematischen Parametern des Schleifens mittels DDG ohne vorhergehendes Ätzen mit alkalischem Ätzmittel wurde eine Asymmetrie des vorder- zu rückseitigen Materialabtrags hinsichtlich des Anteils am gesamten Materialabtrag von 20 % bis 100 % (nur eine Seite wird abgetragen) festgestellt.

Ein Teil des asymmetrischen Materialabtrags lässt sich auch der mit DDG verknüpften Kinematik zuordnen. Die Nachschärfung der Schleifräder durch kontinuierliche Abnutzung während des Schleifvorgangs ist aus kinematischen Gründen leicht asymmetrisch. Die Topfschleifscheiben drehen sich gegenläufig (Drehrichtungen 30 und 31 in Fig. 2), und das über den Rand des Wafers zum Zentrum einwärts schleifende Schleifrad (in Fig. 2 das linke Schleifrad 32 mit Drehrichtung 30) schärft sich wegen höherer Abnutzung stärker, da es gegen die scharfe Wafer-Kante anläuft, wobei Schleifkorn aus der Schleifradbindung herausbricht, und erzeugt einen höheren Materialabtrag vom Wafer als das zum Rand des Wafers hin auswärts schleifende Schleifrad (in Fig. 2 das rechte Schleifrad 33 mit Drehrichtung 31). Dieses Phänomen kann jedoch kompensiert werden, indem die Spindeln nicht vollständig symmetrisch auf die Mittelebene der Wasserkissen zustellen, sondern auf eine um den Betrag der zuvor ermittelten Differenz der Abnutzungen beider Topfschleifscheiben axial in Richtung des auswärts schleifenden Schleifrads parallel zur Mittelebene verschobenen Ebene.

Ein asymmetrischer Materialabtrag kann auch an der Leistungsaufnahme der Wechselrichter (Inverter) abgelesen werden, die erforderlich ist, um die vorgewählte Drehzahl der Schleifscheiben aufrecht zu erhalten. Dabei korrespondiert eine geringere Leistungsaufnahme (geringerer Spindelstrom) mit einem schleiffreudigeren und eine höhere Leistungsaufnahme (höherer Spindelstrom) mit einem weniger schleiffreudigen, stumpfen Schleifrad.

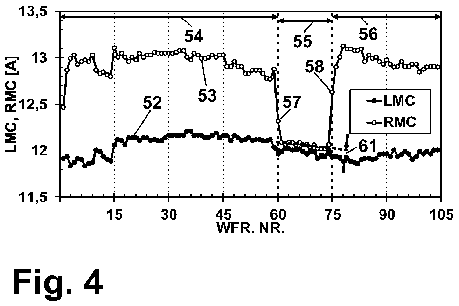

Fig. 4 zeigt Kurven 52 und 53 der maximalen Stromaufnahme (in Ampere) während des Schleifens mittels DDG einer Reihe von Wafern. Die Kurve 52 (LMC, left max current) ist der linken Spindel mit auswärts schleifendem Schleifrad zugeordnet, die Kurve 53 (RMC, right max current) der rechten Spindel mit einwärts schleifendem Schleifrad. Die Abszisse zeigt die fortlaufende Nummerierung der geschliffenen Wafer. Im Bereich 54 wurden zunächst in einem ersten Vergleichsbeispiel Wafer geschliffen, die nach Drahttrennläppen nicht geätzt worden waren, dann in einem ersten Beispiel im Bereich 55 Wafer, die erfindungsgemäß nach Drahttrennläppen geätzt worden waren, und schließlich wieder im Bereich 56 Wafer, die in einem zweiten Vergleichsbeispiel nicht geätzt worden waren. In den Bereichen 54 und 56 sind die Spindelströme stark unterschiedlich, die Schleifscheiben unterschiedlich scharf und schnittfreudig und die resultierenden Materialabträge von den Wafern vorder- und rückseitig stark unterschiedlich mit dem Resultat einer unebenen Form der Wafer nach der Bearbeitung mittels DDG.

Im Bereich 55, der eine erfindungsgemäße Vorgehensweise repräsentiert, sind die Spindelströme nahezu ausgeglichen, beide Schleifräder annähernd gleich scharf und schnittfreudig, und der resultierende Materialabtrag beider Seiten der Wafer ist weitgehend symmetrisch. Der noch verbliebene, geringfügige Unterschied 61 der Spindelströme entspricht dem Betrag, der aufgrund der Kinematik des Schleifens mittels DDG zu erwarten ist. Die Spindeldrehzahl betrug 6000/min, die Waferdrehzahl 35/min. Durch leichte Erhöhung der Drehzahl der Spindel mit auswärts schleifendem Schleifrad gegenüber der Drehzahl der anderen Spindel lässt sich dieser geringe Unterschied noch kompensieren.

Die Punkte 57 und 58 der Spindelströme beim Wechsel von ungeätzten auf geätzte und wieder zurück von geätzten auf ungeätzte Wafer zeigen den Effekt der Initialschärfung beim ersten Eingriff der Schleifscheiben in die Waferoberfläche. Die Initialschärfung der Topfschleifscheiben bei jedem "Einschleifen" (erster Kontakt von Topfschleifscheibe und Oberfläche des Wafers) fällt bei unterschiedlicher Beschaffenheit der Vorder- und Rückseite des Wafers unterschiedlich für die Topfschleifscheiben aus, und die weniger initial geschärfte Topfschleifscheibe setzt schneller zu und wird schneller stumpf. Das Ätzen der Oberfläche des Wafers nach Drahtsägen homogenisiert die zuvor asymmetrisch geschädigten Vorder- und Rückseiten der Wafer und versieht sie mit einer gleichförmigen Morphologie, die einen symmetrisch, ausbalancierten Einschliff beider Topfschleifscheiben ermöglicht. Der Wechsel erfolgt dabei innerhalb des DDG-Schleifens jeweils nur eines Wafers.

## Patentansprüche

1. Verfahren zur Herstellung von Scheiben aus einem zylindrischen Stab aus Halbleitermaterial mit einer Achse und einer Kennkerbe in der Mantelfläche des Stabs und parallel zur Achse, umfassend in der angegebenen Reihenfolge
(a) das gleichzeitige Abtrennen einer Vielzahl von Scheiben vom zylindrischen Stab mittels Drahtsägen in Gegenwart eines Schneidmittels;
(b) das Ätzen der Scheiben mit einem alkalischen Ätzmittel in einem Ätzbad bei einer Temperatur von 20 °C bis 50 °C und während einer Verweildauer, wobei weniger als 5/1000 einer anfänglichen Scheibendicke als Materialabtrag von jeder der Scheiben entfernt wird; und
(c) das Schleifen der Scheiben mittels simultanem Doppelseitenschleifen mit einem ringförmigen Schleifbelag als Werkzeug.

2. Verfahren nach Anspruch 1, wobei das alkalische Ätzmittel ein Hydroxid eines Alkalimetalls oder eines nichtmetallischen Kations ist, das im Ätzbad gelöst ist.

3. Verfahren nach Anspruch 1 oder Anspruch 2, wobei das alkalische Ätzmittel Kaliumhydroxid (KOH), Natriumhydroxid (NaOH), Ammoniumhydroxid (NH₄OH) oder Tetramethylammoniumhydroxid (TMAH, N(CH₃)₄OH) oder eine Mischung von mindestens zwei dieser Verbindungen umfasst.

4. Verfahren nach einem der Ansprüche 1 bis 3, wobei die Verweildauer der Scheiben 0,5 min bis 15 min beträgt.

5. Verfahren nach einem der Ansprüche 1 bis 4, wobei die Konzentration des alkalischen Ätzmittels im Ätzbad 0,5 bis 10 Gew.-% ist und der Materialabtrag je Scheibe maximal 4,5 µm beträgt.

6. Verfahren nach Anspruch 4 und Anspruch 5, wobei die Temperatur 25°C bis 40 °C, die Verweildauer 1 min bis 6 min und die Konzentration des alkalischen Ätzmittels im Ätzbad 2 Gew.-% bis 6 Gew.-% beträgt.

7. Verfahren nach einem der Ansprüche 1 bis 6, wobei das Drahtsägen als Drahttrennläppen ausgeführt wird, der Draht ein hypereutektoider Stahldraht mit einem Kohlenstoffgehalt von 0,8 Gew.-% bis 1 Gew.-% und einem Durchmesser von 50 µm bis 175 µm ist und das Schneidmittel eine Aufschlämmung (Slurry) aus Siliciumcarbid (SiC) mit einer Korngröße von 7 µm bis 13 µm in Glycol ist.

8. Verfahren nach Anspruch 7, wobei der Draht strukturiert ist und mit einer Vielzahl von Einstülpungen und Ausbuchtungen in Richtungen senkrecht zu einer Drahtachse versehen ist.

9. Verfahren nach einem der Ansprüche 1 bis 6, wobei das Drahtsägen als Drahttrennschleifen ausgeführt wird, der Draht ein hypereutektoider Stahldraht mit einem Kohlenstoffgehalt von 0,8 Gew.-% bis 1 Gew.-% und mit einem Durchmesser von 50 µm bis 120 µm ist, das Schneidmittel Diamanten einer Korngröße von 4 µm und 20 µm umfasst und die Diamanten mittels galvanischer Bindung mit Nickel, mittels Kunstharzbindung oder mechanisch in der Oberfläche des Drahts verankert sind.

10. Verfahren nach einem der Ansprüche 1 bis 9, wobei der Draht in einer Vielzahl von Paaren von Richtungsumkehrungen um Drahtführungsrollen bewegt wird, ein Paar von Richtungsumkehrungen jeweils ein Bewegen um eine erste Länge in eine erste Drahtlängsrichtung und ein nachfolgendes Bewegen um eine zweite Länge in eine zweite, der ersten Drahtlängsrichtung genau entgegengesetzte Richtung umfasst und die erste Länge größer als die zweite Länge gewählt wird.

11. Verfahren nach einem der Ansprüche 1 bis 10, wobei der ringförmige Schleifbelag Diamant umfasst, der keramisch gebunden ist und eine Korngröße von 0,5 µm bis 12 µm aufweist.

12. Verfahren nach Anspruch 11, wobei die Korngröße 1,5 µm bis 6 µm beträgt.
